# EUROPEAN PATENT SPECIFICATION

(11) **EP 0 370 542 B1**
(45) Date of publication and mention of the grant of the patent: **25.01.1995**
(21) Application number: 89202667.5
(22) Date of filing: 23.10.1989
(51) Int. Cl.: C23C 14/56, C23C 16/54, C21D 9/56

(54) **Sealing element for feeding through at least one elongated object such as wire and a vacuum apparatus provided with one or more of such sealing elements**
Dichtungselement zur Durchführen mindestens eines langgestreckten Gegenstandes, z.B. Draht, und mit einem oder mehreren solchen Dichtungselementen versehene Vakuumanlage
Elément d'étanchéité adapté au passage d'au moins un objet de forme allongée, tel qu'un fil métallique, et dispositif sous vide utilisant un ou plusieurs de ces éléments

(30) Priority: 16.11.1988 NL 8802822
(43) Date of publication of application: 30.05.1990
(73) Proprietor: N.V. BEKAERT S.A., 8550 Zwevegem (BE)
(72) Inventor: Gobin, Guy, B-8400 Oostende (BE); de Doncker, Geert, B-9881 Bellem (BE); Colpaert, Alex, B-9870 Zulte (BE); van Wassenhove, Norbert, B-9220 Merelbeke (BE); Hoogewijs, Robert, B-9720 De Pinte (BE); Fiermans, Lucien, B-9000 Gent (BE); de Gryse, Roger, B-9250 Oosterzele (BE); Vennik, Joost, B-9880 Aalter (BE)

(56) References cited:
- EP-A- 0 272 710
- FR-A- 1 545 284
- FR-A- 2 315 645
- US-A- 3 669 065

## Description

The invention relates in the first instance to a sealing element to be applied when feeding at least one elongated object such as wire, strip foil, bundles of wire through the wall of a vacuum apparatus, at least comprising a tubular casing that can be attached in sealing relation in the wall of the vacuum apparatus and which has an inside cross-sectional area that is larger than the cross-sectional area of the elongated object.

Such a sealing element for application with a wire is known from the Dutch patent application 8602661 or European patent application No. 0266818 of the present applicant.

In said application is described a sealing element that can be fitted into the wall of a vacuum apparatus, the wire being fed through a casing the length and the free surface of which are dimensioned in such a way that when feeding a wire through, the leakage of ambient air into the interior of the apparatus is reduced in such a way that the pumps connected to the vacuum apparatus, which have a normal, sufficient capacity, are well able to attain and maintain the required vacuum.

It has been found when applying such a sealing element that the required length of the casing can be so long that major practical difficulties are encountered when leading a wire in at one side of the apparatus and leading it out at the other side, as is necessary in the case of wire rupture for instance, which has a detrimental effect on a good production process.

The European patent publication 0272710 deals with a feed-through and sealing element for application in the wall of a vacuum chamber, which element comprises two detachable parts such as a split drawing die. The two parts are pressed against each other under a spring load and abut in this manner in a sealing relation thereby maintaining a free cross sectional area.

A similar sealing element is also known from the French patent 1.545.284. However the free cross sectional area has a rectangular shape. The wall of the feed-through area comprises an elastic liner which is subjected at its outside to a pressure cushion load.

Besides the fact that the parts of the feed through device according to these two prior art documents are not designed for easy assembly and disassembly, the cross sectional area of the passage for the elongated object is not necessarily constant during operation. Indeed the resilient spring or pressure cushion loading enables a temporary expansion of this area as suggested e.g. in column 1 l.47 to 54 of EP 272710A1 thereby increasing temporarily the amount of air inflow to the vacuum chamber.

It is the object of the present invention to provide a solution to said drawback and it is to that end characterised in that the above described sealing element in accordance with the invention, the casing comprises at least two detachable parts that abut in sealing relation, leaving a free space interbetween them for allowing an elongated object to pass through easily, one part comprising a hollow or recess and the other part a bulge or projection fitting into said recess, thereby forming said free space which tapers down from the attachment side towards the opposite side.

The application of a casing that consists of several parts allows a wire to be fed through very simply and quickly in the event of a wire rupture but also when starting the vacuum method. A simple laying-in of the wire can take place by removing one part of the casing, while the leading-out at the other side also becomes very simple by removing a part of the casing; the closing, too, can take place very simply and quickly.

As will become clear later, the free cross-sectional area of the casing is relatively large at the place of attachment of the vacuum apparatus so that the feeding-through is in no way hampered there. If so desired, even relatively thick, rigid wires or tubes can be used when feeding through, so that no obstructions are met with inside the vacuum apparatus either.

In the embodiment of the sealing element in accordance with the invention, the free cross-sectional area gradually decreases in the direction of the side opposite the attachment side. as stated in claim 1.

By applying such a taper in free cross-sectional area from the attachment side to the other side of the casing, a further increase in the resistance against inflow of air is obtained.

The description given hereinbefore started from the assumption that the sealing element is applied when loading one single wire into and out of a vacuum apparatus.

In many cases, it will be desirable to feed several wires through a vacuum apparatus at the same time ; to that end, the sealing element in accordance with the invention is carried out as indicated in claim 2.
By carrying out the casing parts of the sealing element in the shape of sheets and by having the sheet-shaped parts abut in sealing relation through the insertion of a resilient sealing means, it is obtained that the inflow of ambient air only takes place via the remaining free surface at the side opposite the attachment side.

Said free surface is the difference between the free surface left vacant by the construction and the total surface that corresponds to the cross-sectional area of the wires fed through.

One sheet-shaped part of the casing then comprises a hollow, whereas the other part of the casing comprises a bulge that fits the hollow. The hollow and the bulge can be adjusted to each other in such a way that either a free cross-sectional area is obtained that is constant over the whole length of the casing; also, such a version of the hollow and the bulge can be present that the free cross-sectional area for feeding wire through decreases in the direction of the side of the casing opposite the attachment side.

A certain degree of wear of the casing material can occur when feeding wire through the relatively narrow aperture at the side opposite the attachment side.

With very great advantage in order to reduce wear, the side opposite the attachment side is provided with detachably mounted inserts between which is a free cross-sectional area for feeding through several wires. In particular, these inserts can be made of a wear-resistant material such as silicon carbide, tungsten carbide, aluminium oxide and the like.

The invention also relates to a vacuum apparatus for the treatment of wire-shaped material provided with one or more sealing elements for continuously leading wire material into and out of the vacuum apparatus, characterised in that one or more sealing elements are applied as described hereinbefore in accordance with the invention.

The invention will hereinafter be described with reference to the drawing, in which:
- fig. 1: represents a perspective view of a sealing element in accordance with the invention, the sheet-shaped parts of the element being detached from each other;
- fig. 2: represents a section along line II-II′ in fig. 3 through the sealing element in accordance with the invention;
- fig. 3: represents a section along line III-III′ through the sealing element according of fig. 2; and
- fig. 4: is a partial sectional view of a sealing element that is provided with wear-resistant inserts.

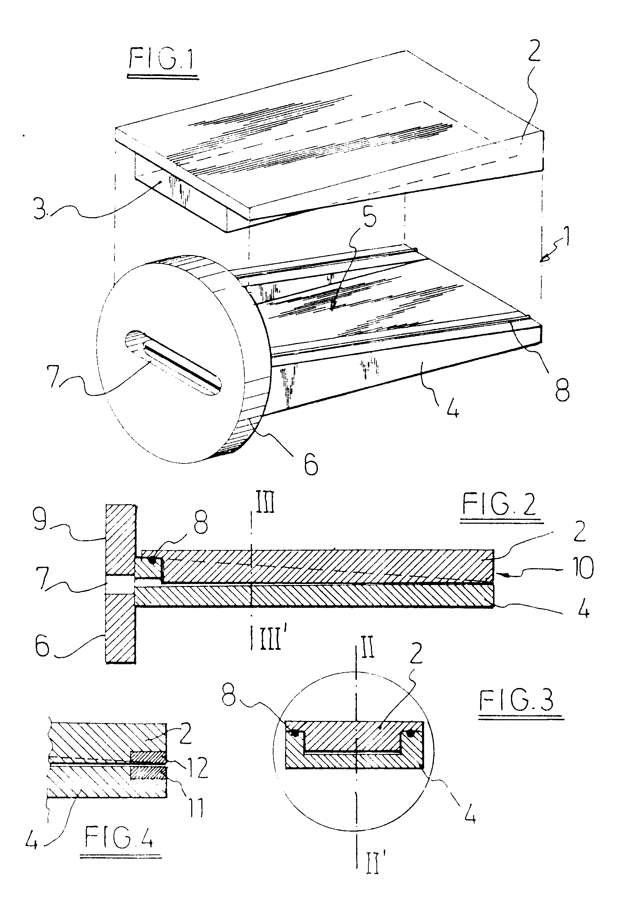

Figure 1 shows a sealing element 1 that is suitable for feeding through several wires such as steel wires at the same time.

The sealing element 1 comprises a casing that consists of the parts 2 and 4, the casing part 2 comprising a bulge 3 and the casing part 4 a hollow 5. The bulge 3 and the hollow 5 fit together; a resilient sealing means 8 is present in the casing part 4 for the sealing conjunction of the sheet-shaped parts 2 and 4.

The bulge 3 and the hollow 5 are adjusted to each other in such a way that a free cross-sectional area is left for feeding wires through that connects with the feed-through aperture 7 made in the flange 6 that is attached onto or into the wall of a vacuum apparatus.
When wire is fed through, the sheet-shaped casing part 2 is removed from the sheet-shaped casing part 4; the size of the aperture 7 is such that several wires can be fed through effortlessly. When the wire or wires have been fed through the vacuum apparatus and a sealing element at the other side of the apparatus, auxiliary means being used if so desired, the sheet-shaped part 2 is put back in its place and attached in sealing relation onto the sheet-shaped casing part 4 with the aid of suitable means. The means of attachment can consist of simple screws; it is also possible to use clamping means that are simple to operate and with which a sealing conjunction of the casing parts 2 and 4 can be effected by a simple movement of the hand.

By varying the diameter of the sealing means 8, the free cross-sectional area can be varied as well. Preferably, however, spacers or distance pieces are used to regulate the cross-sectional area.

Figure 2 is a sectional representation of the sealing element 1 of figure 1; the same parts are indicated with the same reference numbers. The attachment side of the sealing element is indicated with 9; the opposite side is indicated with 10. The sealing means 8 is fitted in a groove that extends over three of the four perimeter sides of the casing leaving on one perimeter side only a free cross-sectional area connected to the ambient air through which a number of wires can be fed.

In figure 2 is shown that the free cross-sectional area of the space left between the sheets 2 and 4 decreases from the attachment side 9 to the opposite side 10.

Figure 3 represents a section through the sealing element of fig. 1 and 2 along line III-III′ in figure 2.

Here too, the location of the sealing means 8 is clearly visible.

Finally, in figure 4 is indicated that the sealing element on the side with the smallest cross-sectional area (i.e. the side opposite the attachment side of the sealing element) is provided with wear-resistant inserts 11 and 12 with which a wearing out of said part with the smallest cross-sectional area is prevented.
The sealing element described hereinbefore can be applied when treating wire-shaped material in a vacuum apparatus. In this context, a vacuum apparatus is to be understood as referring to an apparatus that can carry out a treatment at a pressure that is lower than the atmospheric pressure and as regards the nature of the treatments, the treatments in mind are treatments such as vacuum coating, cathode sputtering, plasma deposition, sputter etching etc.

In the above and foregoing, the sealing element has been described mainly as sealing element for application with wire-shaped material.

It will be clear that in particular the above described sealing element for application with several wires at the same time, can also be successfully applied for feeding a band or strip-shaped material through a vacuum apparatus. Excellent results are also obtained when treating such material that deviates from the wire shape with the aid of the sealing element in accordance with the invention.

## Claims

1. A sealing element (1) for attachment in the wall of a vacuum apparatus and for feeding at least one elongated object, through said wall, said element (1) having an attachment side (9) and an opposite side (10) and comprising at least two detachable casing parts (2, 4) that abut in sealing relation thereby leaving a free space interbetween them for allowing said elongated object to pass through, characterized in that one casing part (4) comprises a hollow or recess (5) and the other part (2) comprises a bulge or projection (3) fitting into said recess (5) thereby forming said free space which tapers down from the attachment side (9) towards the opposite side (10).

2. A sealing element according to claim 1 wherein the cross section of the free space, perpendicular to the longitudinal direction of the elongated object, is rectangular.

3. A sealing element according to claim 1 or 2 whereby the casing parts (2, 4) abut in sealing relation by the insertion of a sealing means (8) that extends over the perimeter sides of the casing leaving only the opposite side (10) free.

4. A sealing element according to claim 3, whereby said sealing means (8) comprises a resilient strip inserted into a groove extending on said perimeter sides.

5. A sealing element according to claim 3 or 4 comprising further attachment or clamping means to effect the sealing relation between casing parts (2, 4) with an adjustable free space interbetween said parts.

6. A sealing element according to claim 1 wherein on the side (10) opposite the attachment side (9) the casing is provided with detachably mounted inserts (11, 12) leaving the free space interbetween.

7. A sealing element in accordance with claim 6, wherein the inserts (11, 12) are made of wear-resistant material.

8. A vacuum apparatus for the treatment of elongated objects provided with one or more sealing elements for continuously passing said objects into and out of the apparatus and wherein one or more sealing elements are mounted in accordance with any of the claims 1 to 7.

9. A vacuum apparatus according to claim 8 for vacuum coating, cathode sputtering, plasma deposition or sputter etching of the objects.

10. A vacuum apparatus according to claim 8 or 9 for the treatment of several wires at the same time.

## Patentansprüche

1. Dichtelement (1) zur Befestigung in der Wandung einer Vakuumeinrichtung und zur Einführung mindestens eines langgezogenen Gegenstandes durch die Wandung, wobei das Element (1) eine Befestigungsseite (9) und eine gegenüberliegende Seite (10) sowie mindestens zwei voneinander lösbare Gehäuseteile (2, 4) enthält, welche abdichtend aneinander liegen, unter Aussparung eines freien Raums zur Hindurchführung des langgezogenen Gegenstandes zwischen diesen, dadurch gekennzeichnet, daß ein Gehäuseteil (4) eine Ausnehmung oder Vertiefung (5) und das andere Teil (2) eine Erhöhung oder einen hervortretenden Teil (3) aufweist, welcher in die Vertiefung (5) unter Bildung des freien Raums einpaßbar ist, der sich von der Befestigungsseite (9) nach der gegenüberliegenden Seite (10) hin verjüngt.

2. Dichtelement nach Anspruch 1, dem der Querschnitt des freien Raums, senkrecht zur Längsrichtung des langgezogenen Gegenstandes, rechteckig ist.

3. Dichtelement nach Anspruch 1 oder 2, in dem die Gehäuseteile (2, 4) aufgrund der Einführung eines Dichtmittels (8), das sich über die Außenseiten des Gehäuses so erstreckt, daß nur die gegenüberliegende Seite (10) freibleibt, abdichtend aneinanderliegen.

4. Dichtelement nach Anspruch 3, in dem das Dichtmittel (8) einen elastischen Streifen umfaßt, der in eine sich über die genannten Außenseiten erstreckende Nut eingebracht wird.

5. Dichtelement nach Anspruch 3 oder 4, ferner umfassend Befestigungs- oder Haltemittel für die Abdichtung zwischen den Gehäuseteilen (2, 4) unter Aussparung eines einstellbaren freien Raums zwischen diesen Teilen.

6. Dichtelement nach Anspruch 1, in dem auf der der Befestigungsseite (9) gegenüberliegenden Seite (10) das Gehäuse mit lösbar angebrachten Einsatzstücken (11, 12) unter Aussparung des freien Raums zwischen diesen versehen ist.

7. Dichtelement nach Anspruch 6, in dem die Einsatzstücke (11, 12) aus einem verschleißfesten Material bestehen.

8. Vakuumvorrichtung für die Behandlung langgezogener Gegenstände mit einem oder mehreren Dichtelementen, um die genannten Gegenstände in die Vorrichtung einzuführen oder aus dieser zu entfernen, und bei welcher ein oder mehrere Dichtelemente gemäß einem jeden der Ansprüche 1 bis 7 angebracht sind.

9. Vakuumvorrichtung nach Anspruch 8 zur Vakuumbeschichtung, Kathodenzerstäubung, Plasmaablagerung oder zum SputterÄtzen der Gegenstände.

10. Vakuumvorrichtung nach Anspruch 8 oder 9 für die Behandlung mehrerer Drähte gleichzeitig.

## Revendications

1. Elément d'étanchéité (1) destiné à être fixé dans la paroi d'un appareil à vide et à faire passer au moins un objet de grande longueur à travers ladite paroi, ledit élément (1) ayant un côté de fixation (9) et un côté opposé (10) et comprenant au moins deux pièces (2, 4) de boîtier détachables, qui s'appliquent l'une sur l'autre dans une relation de joint étanche, en ménageant entre elles un espace libre, pour laisser passer ledit objet de grande longueur, caractérisé en ce qu'une première pièce (4) du boîtier présent une cavité ou un évidement (5) et l'autre pièce (2) présente un renflement ou bossage (3) qui s'ajuste dans ledit évidement (5) en donnant ainsi audit espace libre une forme une s'amincit du côté de fixation (9) vers le côté opposé (10).

2. Elément d'étanchéité selon la revendication 1, dans lequel la section de l'espace libre, perpendiculairement à la direction longitudinale de l'objet de grande longueur, est rectangulaire.

3. Elément d'étanchéité selon la revendication 1 ou 2, dans lequel les pièces (2, 4) du boîtier sont appliquées l'une sur l'autre dans une relation de joint étanche par l'insertion d'un moyen d'étanchéité (8) qui s'étend sur les côtés du périmètre du boîtier, en ne laissant libre que le côté opposé (10).

4. Elément d'étanchéité selon la revendication 3, dans lequel ledit moyen d'étanchéité (8) comprend une bande élastique inserée dans une rainure qui s'étend sur lesdits côtés du périmètre.

5. Elément d'étanchéité selon la revendication 3 ou 4, comprenant en outre des moyens de fixation ou de serrage pour établir la relation de joint étanche entre les pièces (2, 4) du boîtier, avec un espace libre réglable entre lesdites pièces.

6. Elément d'étanchéité selon la revendication 1, dans lequel, sur le côté (10) qui est à l'opposé du côté de fixation (9), le boîtier est équipé d'insertions (11, 12) montées de façon détachable en laissant l'espace libre entre ces insertions.

7. Elément d'étanchéité selon la revendication 6, dans lequel les insertions (11, 12) sont faites d'une matière résistante à l'usure.

8. Appareil à vide pour le traitement d'objets de grande longueur équipé d'un ou plusieurs éléments d'étanchéité permettant de faire entrer lesdits objets en continu dans l'appareil et de les faire sortir en continu de cet appareil, et dans lequel un ou plusieurs éléments d'étanchéité sont montés conformément à l'une quelconque des revendications 1 à 7.

9. Appareil à vide selon la revendication 8, destiné au revêtement par évaporation sous vide, à la pulvérisation cathodique, à la déposition au plasma et à la gravure cathodique des objets.

10. Appareil à vide selon la revendication 8 ou 9, destiné à traiter plusieurs fils simultanément.
